# EUROPEAN PATENT SPECIFICATION

(11) **EP 2 197 061 B1**
(45) Date of publication and mention of the grant of the patent: **06.04.2016**
(21) Application number: 09178477.7
(22) Date of filing: 09.12.2009
(51) Int. Cl.: H01L 51/52, H01L 27/32

(54) **Organic light emitting diode display**
Organische lichtemittierende Diodenanzeige
Affichage à diode électroluminescente organique

(30) Priority: 10.12.2008 KR 20080125382
(43) Date of publication of application: 16.06.2010
(73) Proprietor: Samsung Display Co., Ltd., Gyeonggi-do (KR)
(72) Inventor: Jung, Woo-Suk, Gyunggi-Do (KR); Kwak, Noh-Min, Gyunggi-Do (KR); Kim, Eun-Ah, Gyunggi-Do (KR); Park, Soon-Ryong, Gyunggi-Do (KR); Lee, Joo-Hwa, Gyunggi-Do (KR); Jeon, Hee-Chul, Gyunggi-Do (KR); Jeong, Chul-Woo, Gyunggi-Do (KR); Jeong, Hee-Seong, Gyunggi-Do (KR)
(74) Representative: Gulde & Partner

(56) References cited:
- EP-A2- 1 677 336
- EP-A2- 1 930 968
- WO-A1-2008/051022
- WO-A1-2008/056868
- US-A1- 2002 057 053
- US-A1- 2006 158 096
- US-A1- 2006 192 487
- US-A1- 2007 096 612
- US-A1- 2007 108 899
- US-A1- 2007 200 492
- US-A1- 2008 042 136

## Description

### BACKGROUND OF THE INVENTION

### Field of the Invention

The present invention relates to an organic light emitting diode display, and more particularly, to a visibility-enhanced organic light emitting diode display.

### Description of the Related Technology

An organic light emitting diode (OLED) display has a plurality of organic light emitting diodes each including a hole injection electrode, an organic emissive layer, and an electron injection electrode. The electrons and the holes are combined with each other in the organic emissive layer to thereby generate excitons. When the excitons shift from an excited state to a ground state, energy is generated, and light is emitted by way of the energy. The organic light emitting diode display displays images based on the emitted light.

The above information disclosed in this Background section is only for enhancement of understanding of the background of the invention and therefore it may contain information that does not form the prior art that is already known in this country to a person of ordinary skill in the art.

Several organic light emitting diodes are disclosed in US 2007/108899 A1, US 2006/192487 A1, US 2008/042136 A1, US 2006/158096 A1, US2007/096612 A1, WO 2008/056868 A1 and EP 1930968 A2. The organic light emitting diodes showing different partition and black matrices which are arranged in an area different from an emissive area defined by an overlapping area of anode, emission layer and cathode. whereas a light absorption pattern which partitions the emissive area of each organic light emitting diode into a plurality of sub-emissive areas is not described.

Further embodiments of organic light emitting diodes are described in EP 1 677 336 A2, US 2007/200492 A1, US 2002/057053 A1. A plasma display apparatus configured corresponding to the organic light emitting diodes of EP 1 677 336 A2 is disclosed in WO 2008/051022 A1.

### SUMMARY OF CERTAIN INVENTIVE ASPECTS

The present invention concerns an organic light emitting diode display having advantages of enhancing visibility according to the appended claims.

Another aspect of the present invention is an organic light emitting diode display including first and second display panels facing each other. The first display panel has a plurality of organic light emitting diodes each with an emissive area, and the second display panel has a light absorption pattern for partitioning the emissive area of the organic light emitting diode into four to ten sub-emissive areas.

The unit width the light absorption pattern ranges between 1 µm and 9µm.

The light absorption pattern is formed with a stripe pattern, which crosses the longitudinal direction of the emissive area of the organic light emitting diode or with a lattice pattern to partition the emissive area of the organic light emitting diode.

The light absorption pattern may contain one or more materials selected from titanium oxide (TiO2), iron oxide (FeO2), chromium (Cr), and silver (Ag).

The light absorption pattern may be formed with a black inorganic material.

The light absorption pattern may be formed with an organic material containing black particulates.

The black particulates may contain one or more materials selected from carbon black, and tin and tin alloys, with an average diameter in a range of 1 nm to 300nm.

The light absorption pattern may be formed through photolithography.

Another aspect of the invention is an organic light emitting diode display comprising: a first display panel comprising a plurality of organic light emitting diodes (OLEDs), wherein an emissive area and a non-emissive area are formed for each of the OLEDs, wherein the emissive area is configured to emit light, and wherein the non-emissive area is configured not to emit light; and a second display panel facing the first display panel, wherein the second display panel comprises a light absorption pattern which partitions the emissive area of each OLED into a plurality of sub-emissive areas.

In the above OLED display, the light absorption pattern is a stripe pattern which comprises a plurality of stripes, and wherein the plurality of stripes are substantially parallel with each other and cross the emissive area of the OLED, or the light absorption pattern is a lattice pattern, wherein the lattice pattern comprises i) a first plurality of stripes and ii) a second plurality of stripes which cross the first plurality of stripes, and wherein the first and second plurality of stripes cross the emissive area of the OLED. In the above OLED display, the light absorption pattern preferably contains one or more materials selected from the group consisting of titanium oxide (TiO2), iron oxide (FeO2), chromium (Cr), and silver (Ag). In the above OLED display, the light absorption pattern preferably comprises a black inorganic material.

In the above OLED display, the light absorption pattern preferably comprises an organic material containing black particulates. In the above OLED display, the black particulates preferably comprise one or more materials selected from the group consisting of carbon black, tin, and tin alloys with an average diameter in a range of preferably about 1 nm to about 300nm. In the above OLED display, the display preferably does not require a separate anti-reflection member, i.e. the display preferably does not comprise any anti-reflection layer or light absorbing layer formed under the first (lower) electrode layer. Furthermore, the display preferably does not comprise any polarizing layer formed between the second (upper) electrode and the second substrate (second display panel). A separate anti-reflection member is understood as a member that is adapted to reduce the reflection of incident light by at least 10%, preferably by at least 30%. In the above OLED display, the light absorption pattern preferably partitions the emissive area of the OLED into four to ten sub-emissive areas.

Preferably, each pixel of the display comprises one organic light emitting diode, at least two thin film transistors, and at least one capacitor.

Preferably, the light absorption pattern comprises an optical transmittance (ratio of transmitted light intensity and incident light intensity) for visible light (380 nm - 760 nm) of less than 20%, more preferably less than 10%, more preferably less than 5%, more preferably less than 2%, more preferably less than 1% and still more preferably less than 0.1 %.

Preferably, the first display panel is a first substrate and the second display panel is a second substrate. Preferably, the first display panel and the second display panel consist of a transparent material for visible light comprising an optical transmittance of more than 70%, more preferably more than 80%, more preferably more than 90%, more preferably more than 95% and still more preferably more than 99%. Preferably, the first display panel and the second display panel consist of glass or plastic. Preferably, the first display panel and the second display panel consist of one material, i.e. the first display panel and the second display panel do not comprise more than one layer or more than one material. Preferably, the first display panel and the second display panel comprise a rectangular shape and extend over the whole emissive area of the organic light emitting diodes. In the sense of the invention, the expression "display panel" may also be referred to as "substrate" and vice versa.

The light absorption pattern is a regular pattern in form of a stripe pattern or a lattice pattern. The light absorption pattern partitions each emissive area of the organic light emitting diodes into four to ten sub-emissive areas, more preferably into five to nine sub-emissive areas and still more preferably into six to eight sub-emissive areas. The expression "partition" or "divide" the emissive area into a plurality sub-emissive areas means that the light absorption pattern is arranged such (on one of the substrates) in relation to the emissive area of the organic light emitting diodes that a projection of the light absorption pattern onto the emissive area (organic material interposed between two electrodes) divides the emissive area into a plurality sub-emissive areas, the projection extending along an axis which is perpendicular to the (preferably planar) surfaces of the substrates (or parallel to the normal vector of the substrates).

Preferably, each of the sub-emissive areas has the same size. Preferably, each of the sub-emissive areas has the same shape. Preferably, the arrangement of the sub-emissive areas is uniform for all organic light emitting diodes of the display. Preferably the number of sub-emissive areas, into which the emissive area of each of the organic light emitting diodes is divided, is adapted such that a reflection rate (ratio of reflected light intensity and incident ambient light intensity) is less than 0.45, more preferably less than 0.45, and a transmission rate (ratio of light intensity emitted by organic light emitting diodes and outcoupled light intensity of the emitted light) is more than 0.55, more preferably more than 0.60.

Another aspect of the invention is an organic light emitting diode display comprising: first and second substrates facing each other; an organic light emitting diode (OLED) unit configured to emit light, wherein the OLED unit is formed between the first and second substrates; a driving thin film transistor (TFT) formed between the two substrates and configured to drive the OLED unit; and a light absorption pattern formed on one of the two substrates.

In the above OLED display, the light absorption pattern is further configured to divide the light emissive area of the OLED unit into parallel stripes. In the above OLED display, the light absorption pattern is preferably further configured to divide the light emissive area of the OLED unit into polygonal shapes. In the above OLED display, an emissive area and a non-emissive area are formed in the OLED, wherein the emissive area is configured to emit light, wherein the non-emissive area is configured not to emit light, and wherein the light absorption pattern is configured to partition the emissive area of the OLED into a plurality of sub-emissive areas.

In the above OLED display, the light absorption pattern comprises a plurality of stripes, and wherein the plurality of stripes are substantially parallel with each other and cross the emissive area of the OLED. In another embodiment of the above OLED display, the light absorption pattern is a lattice pattern, wherein the lattice pattern comprises i) a first plurality of stripes and ii) a second plurality of stripes which cross the first plurality of stripes, and wherein the first and second plurality of stripes cross the emissive area of the OLED. In the above OLED display, the light absorption pattern is preferably formed on the second substrate and does not contact the OLED unit. In the above OLED display, the light absorption pattern is preferably formed on the first substrate and does not contact the OLED unit.

Still another aspect of the invention is an organic light emitting diode display comprising: a first substrate; a driving thin film transistor (TFT) formed over the first substrate; an organic light emitting diode (OLED) unit configured to emit light and electrically connected to the driving TFT; a second substrate facing the first substrate and formed over the OLED unit and driving TFT; and means for dividing an emissive area of the OLED unit.

In the above OLED display, the dividing means is preferably formed on the second substrate, and wherein the dividing means comprises at least one of a stripe pattern and a lattice pattern.

### BRIEF DESCRIPTION OF THE DRAWINGS

FIG. 1 is a layout view of an organic light emitting diode display according to an exemplary embodiment of the present invention.
FIG. 2 is a cross-sectional view of the organic light emitting diode display taken along the II-II line of FIG. 1.
FIG. 3 is a perspective view of a second display panel with a light absorption pattern.
FIG. 4 is a perspective view of a second display panel with a light absorption pattern according to another exemplary embodiment of the present invention.
FIG. 5 is a graph illustrating an external light reflection rate and an internal light transmittance rate as a function of the number of sub-emissive areas per pixel.

### DETAILED DESCRIPTION OF CERTAIN INVENTIVE EMBODIMENTS

Generally, the organic light emitting diode display has an emissive characteristic, and differs from a liquid crystal display (LCD) in that it does not require a separate light source such that it has comparatively reduced thickness and weight. Furthermore, as the organic light emitting diode display has high-quality characteristics such as lower power consumption, high luminance, and a short response time, it has been spotlighted as a next generation display device for portable electronic appliances.

The hole injection electrodes or the electron injection electrodes of the organic light emitting diode display, and various other metal wires thereof, reflect external light incident from the outside. When the organic light emitting diode display is used in bright areas, the black color expression and the contrast thereof are poor due to the reflection of external light so that the visibility is deteriorated.

Embodiments of the present invention will be described more fully hereinafter with reference to the accompanying drawings, in which exemplary embodiments of the invention are shown. As those skilled in the art would realize, the described embodiments may be modified in various different ways, all without departing from the scope of the present invention.

Furthermore, as the size and thickness of the respective structural components shown in the drawings are arbitrarily illustrated for explanatory convenience, the present invention is not necessarily limited thereto.

Parts that are irrelevant to the description are omitted in order to clearly describe the present invention, and like reference numerals designate like elements throughout the specification.

In the drawings, the thickness of layers, films, panels, regions, etc., or the thickness of some portions thereof, are exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present.

Furthermore, even though an active matrix (AM) organic light emitting diode (OLED) display having a 2Tr-1 Cap structure with two thin film transistors (TFT) and one capacitor at each pixel is illustrated in the appended drawings, the present invention is not limited thereto. The organic light emitting diode display may have three or more thin film transistors and two or more capacitors at each pixel, and various structures with separate wires. A pixel is a minimum unit for image display, and the organic light emitting diode display displays images by way of a plurality of pixels.

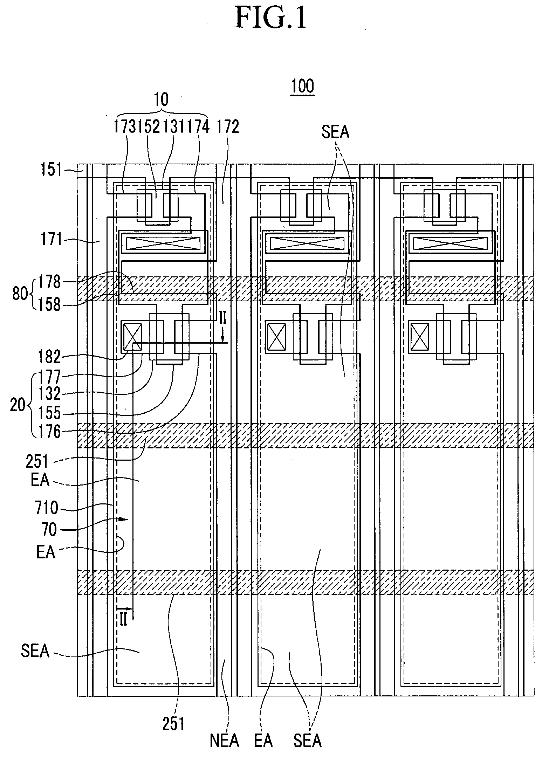

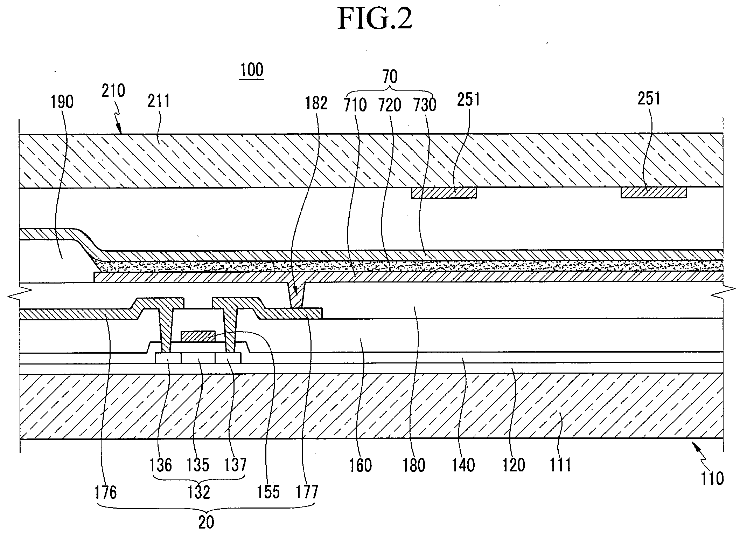

An exemplary embodiment of the present invention will now be described with reference to FIG. 1 and FIG. 2.

As shown in FIG. 1 and FIG. 2, an organic light emitting diode display 100 includes first and second display panels 110 and 210. FIG. 1 is a layout view of a pixel structure around the first display panel 110. FIG. 2 is a cross-sectional view of the first and second display panels 110 and 210 taken along the II-II line of FIG. 1.

The first display panel 110 includes a switching thin film transistor 10, a driving thin film transistor 20, a capacitor 80, and an organic light emitting diode 70, which are formed on a first substrate 111 at each pixel. The first display panel 110 further includes gate lines 151 arranged in one direction, data lines 171 crossing the gate lines 151 in an insulated manner, and common power lines 172. Here, a pixel is defined by taking a gate line 151, a data line 171, and a common power line 172 as a boundary, but is not limited thereto.

The organic light emitting diode 70 includes a first electrode 710, an organic emissive layer 720 formed on the first electrode 710, and a second electrode 730 formed on the organic emissive layer 720. The first electrode 710 is a positive (+) electrode or anode being a hole injection electrode, and the second semi-transparent electrode 730 is a negative (-) electrode or cathode being an electron injection electrode. However, the present invention is not necessarily limited thereto, and depending upon the driving method of the organic light emitting diode display 100, the first electrode 710 may be a cathode and the second electrode 730 may be an anode. Holes and electrons are injected from the first and second electrodes 710 and 730 into the organic emissive layer 720. When excitons being combinations of the injected holes and electrons shift from the excited state to the ground state, light is emitted.

Furthermore, with an organic light emitting diode display according to an exemplary embodiment of the present invention, the organic light emitting diode 70 emits light from the organic emissive layer 720 in the direction opposite to the first electrode 710, that is, in the direction of the second electrode 730, to thereby display images. That is, in this embodiment, the organic light emitting diode display 100 is a front emission type.

The capacitor 80 includes first and second capacitor electrode plates 158 and 178, and a gate insulating layer 140 interposed between the two capacitor electrode plates 158 and 178. The gate insulating layer 140 functions as a dielectric. The capacitance is determined by charges charged at the capacitor 80 as well as voltages applied to the two capacitor electrode plates 158 and 178.

The switching thin film transistor 10 includes a switching semiconductor layer 131, a switching gate electrode 152, a switching source electrode 173, and a switching drain electrode 174, and the driving thin film transistor 20 includes a driving semiconductor layer 132, a driving gate electrode 155, a driving source electrode 176, and a driving drain electrode 177.

The switching thin film transistor 10 is used as a switch for selecting pixels to emit light. The switching gate electrode 152 is connected to the gate line 151. The switching source electrode 173 is connected to the data line 171. The switching drain electrode 174 is spaced apart from the switching source electrode 173 by a distance, and is connected to the first capacitor electrode plate 158.

The driving thin film transistor 20 applies a driving voltage to the first electrode 710 to excite the organic emissive layer 720 of the organic light emitting diode 70 in the selected pixel. The driving gate electrode 155 is connected to the first capacitor electrode plate 158. The driving source electrode 176 and the second capacitor electrode plate 178 are connected to the common power line 172. The driving drain electrode 177 is connected to the first electrode 710 of the organic light emitting diode 70 through a contact hole 182.

With the above structure, the switching thin film transistor 10 is driven by the gate voltage applied to the gate line 151, and transmits the data voltage applied to the data line 171 to the driving thin film transistor 20. A voltage with a value corresponding to a difference between the common voltage applied from the common power line 172 to the driving thin film transistor 20 and the data voltage transmitted from the switching thin film transistor 10 is stored at the capacitor 80, and a current corresponding to the voltage stored at the capacitor 80 flows to the organic light emitting diode 70 through the driving thin film transistor 20 to thereby excite the organic light emitting diode 70.

Furthermore, the organic light emitting diode 70 includes an emissive area EA (where light is emitted) where the organic emissive layer 720 is interposed between the first and second electrodes 710 and 720 to substantially emit light, and a non-emissive area NEA (where light is not emitted) surrounding the emissive area EA.

The second display panel 210 faces the first display panel 110 to cover the thin film transistors 10 and 20, the capacitors 80, and the organic light emitting diodes 70, and to seal them from the outside. Although not illustrated in the drawings, the first and second display panels 110 and 210 are sealed to each other by way of a sealant disposed along the edges thereof.

The second display panel 210 includes a second substrate 211, and a light absorption pattern 251 (functioning to divide the emissive areas) formed on a surface of the second substrate 211 facing the first display panel 110. In an exemplary embodiment of the present invention, the light absorption pattern 251 is formed on a surface of the second substrate 211 facing the first display panel 110, but is not limited thereto. The light absorption pattern 251 may be formed on a surface of the second substrate 211 opposite to the surface thereof facing the first display panel 110.

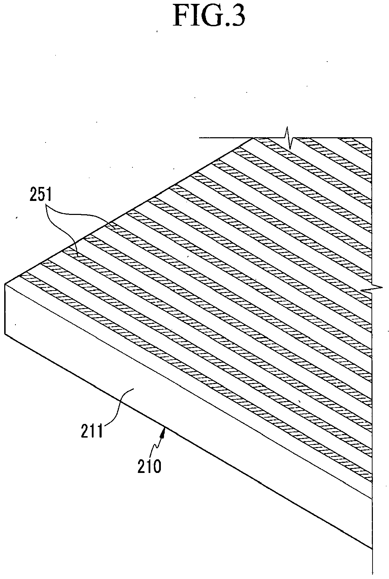

As shown in FIG. 3, in one embodiment, the light absorption pattern 251 is formed with a stripe pattern. The stripe-patterned light absorption pattern 251 is formed in the direction crossing the longitudinal direction of the emissive area EA of the organic light emitting diode 70. Accordingly, the light absorption pattern 251 partitions the emissive area EA of the organic light emitting diode 70 into a plurality of sub-emissive areas SEA.

As shown in FIG. 1, the light absorption pattern 251 partitions one emissive area EA of the organic light emitting diode 70 into four sub-emissive areas SEA. In one embodiment, the light absorption pattern 251 is formed such that four sub-emissive areas SEA are provided at each pixel. However, an exemplary embodiment of the present invention is not limited thereto. The light absorption pattern 251 may variously partition one emissive area EA into two or more sub-emissive areas SEA depending upon need. In another embodiment, the light absorption pattern 251 partitions one emissive area EA of the organic light emitting diode 70 into four to ten sub-emissive areas SEA. In this embodiment, the reflection of external light may be substantially reduced or eliminated without significantly sacrificing the transmittance of light emitted from the organic light. However, the number of partitions may be less than four or greater than ten depending on embodiments. In some experiments, it was noted that if the light absorption pattern 251 forms three or less sub-emissive areas SEA, the transmittance of light emitted from the organic light emitting diode 70 is heightened, but it is difficult to effectively prevent the reflection of external light. It was also noted that if the light absorption pattern 251 form eleven or more sub-emissive areas SEA, the reflection of light is effectively prevented, but the transmittance of light emitted from the organic light emitting diode 70 is extremely lowered.

Furthermore, the light absorption pattern 251 has a unit width in a range between 1 µm and 9µm. The reflection of external light is substantially reduced or eliminated without significantly deteriorating the luminous efficiency of the organic light emitting diode display. In some experiments, it was noted that if the width of the light absorption pattern 251 is less than several micrometers, the effect of preventing the reflection of external light is deteriorated. It was also noted that if the width of the light absorption pattern 251 exceeds several tens of micrometers, the luminous efficiency of the organic light emitting diode display 100 is deteriorated.

Furthermore, the light absorption pattern 251 may be formed with at least one material selected from a metallic material, an inorganic material, and an organic material. Specifically, the light absorption pattern 251 may be formed with a material that is well-adapted to the material of the second substrate 211, or in a way of sealing the first and second display panels 110 and 210 to each other. For example, if the second substrate 211 is formed with glass, or a glass-based material like frit is used as a sealant (not shown) for sealing the first and second display panels 110 and 210, the light absorption pattern 251 is formed with a metallic material or black inorganic material that is capable of enduring a high baking temperature. The metallic material may be titanium oxide (TiO2), iron oxide (FeO2), chromium (Cr), or silver (Ag). Furthermore, the black inorganic material may be selected from various well-known inorganic materials. If an organic material is used as the sealant, or an organic thin film is used as the second substrate 211, the light absorption pattern 251 may be formed with an organic material containing black particulates. The black particulates may be based on carbon black, tin, or a tin alloy with an average diameter ranged from 1 nm to 300nm.

Furthermore, the light absorption pattern 251 may be formed through photolithography as follows. A light absorption layer is first applied onto the second substrate 211, and a photoresist pattern is formed thereon through photolithography using a mask. The light absorption layer is etched using a photoresist pattern to thereby form the light absorption pattern 251.

As described above, with the light absorption pattern 251 of the second display panel 210, the organic light emitting diode display 100 prevents the visibility from being deteriorated due to the reflection of external light, and simultaneously minimizes the loss of light generated from the organic light emitting diode 70 to thereby emit the light to the outside.

A structure of an organic light emitting diode display 100 according to an exemplary embodiment of the present invention will now be described specifically depending upon the sequence of deposition. Furthermore, the structure of a thin film transistor will be described based on the driving thin film transistor 20. The switching thin film transistor 10 will be described simply with respect to differences thereof from the driving thin film transistor.

The first display panel 110 will be firstly described in detail. The first substrate 111 is formed with an insulating material such as glass, quartz, ceramic, or plastic. However, the present invention is not limited thereto. The first substrate member 111 may be formed with a metallic material such as stainless steel.

A buffer layer 120 is formed on the first substrate 111. The buffer layer 120 has a role of preventing the intrusion of impure elements and flattening the surface, and may be formed with a material that is appropriate to the role. For example, the buffer layer 120 may be formed with at least one material selected from silicon nitride (SiNx), silicon oxide (SiOx), and silicon oxynitride (SiOxNy). However, the buffer layer 120 is not necessarily required, and hence may be omitted depending upon the kind of the first substrate 111 and the processing conditions.

A driving semiconductor layer 132 is formed on the buffer layer 120. The driving semiconductor layer 132 is formed with polycrystalline silicon. The driving semiconductor layer 132 has a channel region 135 that is not doped with any impurities, and p+ doped source and drain regions 136 and 137 formed on both sides of the channel region 135. The dopant ion material is a P-type impurity such as boron (B), and may be formed mainly with B₂H₆. The impurity is differentiated depending upon the kinds of the thin film transistors.

With an exemplary embodiment of the present invention, a thin film transistor with a PMOS structure using a P-type impurity is used as the driving thin film transistor 20, but the driving thin film transistor 20 is not limited thereto. A thin film transistor with an NMOS structure or a CMOS structure may also be used as the driving thin film transistor 20.

Furthermore, although the thin film transistor 20 shown in FIG. 2 is a polycrystalline thin film transistor containing polycrystalline silicon, the switching thin film transistor 10 not shown in FIG. 2 may be either a polycrystalline thin film transistor or an amorphous thin film transistor containing amorphous silicon.

A gate insulating layer 140 is formed on the semiconductor layer 132 with silicon nitride (SiNx) or silicon oxide (SiOx). A gate wire including gate electrodes 155 is formed on the gate insulating layer 140. Furthermore, the gate wire includes gate lines 151, first capacitor electrode plates 158, and other wiring lines. The driving gate electrode 155 is overlapped with at least a part of the driving semiconductor layer 132, and particularly with the channel region 135 thereof.

An interlayer insulating layer 160 is formed on the gate insulating layer 140 such that it covers the driving gate electrode 155. The gate insulating layer 140 and the interlayer insulating layer 160 commonly have through holes exposing the source and drain regions 136 and 137 of the driving semiconductor layer 132. The interlayer insulating layer 160 as well as the gate insulating layer 140 are formed with silicon nitride (SiNx) or silicon oxide (SiOx).

A data wire including driving source and drain electrodes 176 and 177 is formed on the interlayer insulating layer 160. Furthermore, the data wire includes data lines 171, common power lines 172, second capacitor electrode plates 178, and other wiring lines. The driving source and drain electrodes 176 and 177 are connected to the source and drain regions 136 and 137 of the driving semiconductor layer 132 via through holes formed at the interlayer insulating layer 160 and the gate insulating layer 140, respectively.

In this way, the driving thin film transistor 20 is formed with the driving semiconductor layer 132, the driving gate electrode 155, and the driving source and drain electrodes 176 and 177. The structure of the driving thin film transistor 20 is not limited to the above, but may be altered in various manners with a structure available to those skilled in the art.

A planarization layer 180 is formed on the interlayer insulating layer 160 such that it covers the data wires 172, 176, 177, and 178. The planarization layer 180 removes a stepped difference and flattens the surface in order to heighten the luminous efficiency of an organic light emitting diode 70 to be formed thereon. Furthermore, the planarization layer 180 has a contact hole 182 at least partially exposing the drain electrode 177.

The planarization layer 180 may be formed with at least one material selected from acrylic resin, epoxy resin, phenolic resin, polyamide resin, polyimide resin, unsaturated polyester resin, polyphenylenether resin, polyphenylenesulfide resin, and benzocyclobutene (BCB).

Furthermore, an exemplary embodiment of the present invention is not limited to the above-described structure, and either one of the planarization layer 180 and the interlayer insulating layer 160 may be omitted.

The first electrode 710 of the organic light emitting diode 70 is formed on the planarization layer 180. That is, the organic light emitting diode display 100 has a plurality of first electrodes 710 disposed at a plurality of pixels, respectively. The plurality of first electrodes 710 are spaced apart from each other by a distance. The first electrode 710 is connected to the drain electrode 177 through the contact hole 182 of the planarization layer 180.

A pixel definition layer 190 having an opening exposing the first electrode 710 is formed on the planarization layer 180. That is, the pixel definition layer 190 has a plurality of openings formed at the respective pixels. The first electrode 710 is disposed corresponding to the opening of the pixel definition layer 190. However, the first electrode 710 is not necessarily disposed only at the opening of the pixel definition layer 190, but may be disposed under the pixel definition layer 190 such that it is at least partially overlapped with the pixel definition layer 190. The pixel definition layer 190 may be formed with a resin such as polyacrylate resin and polyimide resin, or a silica-based inorganic material.

The organic emissive layer 720 is formed on the first electrode 710, and the second electrode 730 is formed on the organic emissive layer 720. In this way, the organic light emitting diode 70 is formed with the first electrode 710, the organic emissive layer 720, and the second electrode 730.

The organic emissive layer 720 is formed with a low molecular organic material or a high molecular organic material. The organic emissive layer 720 may have a multi-layered structure with some or all of an emission layer, a hole injection layer (HIL), a hole transport layer (HTL), an electron transport layer (ETL), and an electron injection layer (EIL). If the organic emissive layer 720 is formed with all of the layers, the hole injection layer (HIL) is formed on the first electrode 710 being the anode, and is sequentially overlaid with the hole transport layer (HTL), the emission layer, the electron transport layer (ETL), and the electron injection layer (EIL).

In one embodiment, as shown in FIG. 2, the organic emissive layer 720 is disposed only within the opening of the pixel definition layer 190, but an exemplary embodiment of the present invention is not limited thereto. The organic emissive layer 720 may be either formed on the first electrode 190 within the opening of the pixel definition layer 190, or placed between the pixel definition layer 190 and the second electrode 730. Specifically, the hole injection layer (HIL), the hole transport layer (HTL), the electron transport layer (ETL), and the electron injection layer (EIL) of the organic emissive layer 720 in addition to the emission layer may be formed on the pixel definition layer 190 as well as on the first electrode 710, as with the second electrode 730, using an open mask. That is, one or more layer components of the organic emissive layer 720 may be interposed between the pixel definition layer 190 and the second electrode 730.

The first and second electrodes 710 and 730 may be formed with a transparent material, or a semi-transparent or reflective conductive material, respectively. The organic light emitting diode display 900 may be a front emission type, a rear emission type, or a both-sides emission type depending upon the kinds of materials for forming the first and second electrodes 710 and 730.

An organic light emitting diode display 100 according to an exemplary embodiment of the present invention is formed as a front emission type. That is, the organic light emitting diode 70 emits light toward the second substrate 210 to thereby display images.

The transparent conductive material may be indium tin oxide (ITO), indium zinc oxide (IZO), zinc oxide (ZnO), or indium oxide (In₂O₃). The reflective material and the semi-transparent material may be lithium (Li), calcium (Ca), lithium fluoride/calcium (LiF/Ca), lithium fluoride/aluminum (LiF/Al), aluminum (Al), silver (Ag), magnesium (Mg), or gold (Au).

The second display panel 210 faces the second electrode 730. The second substrate 211 of the second substrate 210 is formed with a transparent material such as glass and plastic. A light absorption pattern 251 is formed on a surface of the second substrate 211 facing the first display panel 110. The light absorption pattern 251 is stripe-patterned, and partitions the emissive area EA of the organic light emitting diode 70 into a plurality of sub-emissive areas.

Furthermore, although not illustrated in the drawings, a sealant may be disposed along the edges of the first and second display panels 110 and 210 to seal them to each other.

With the above structure, the organic light emitting diode display 100 has enhanced visibility. That is, the organic light emitting diode display 100 prevents the visibility from being deteriorated due to reflection of external light, with the light absorption pattern 251 of the second substrate 210. Furthermore, the organic light emitting diode display 100 may include a common polarization member for preventing reflection of external light, owing to the light absorption pattern 251 of the second substrate 210. Accordingly, the relatively poor luminous efficiency of the organic light emitting diode 100 with the usage of a polarization member can be increased. That is, the luminance and the life span of the organic light emitting diode display 100 can be improved.

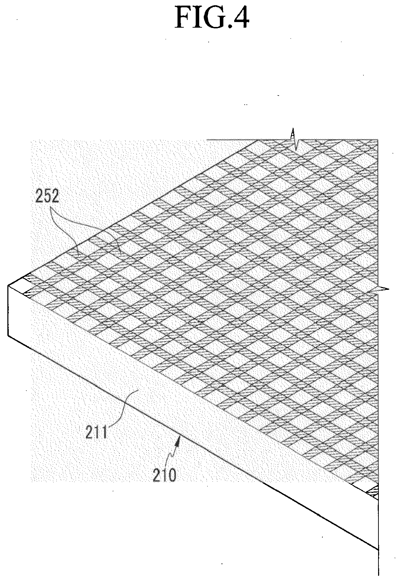

FIG. 4 illustrates a light absorption pattern 252 of a second display panel 210 according to another exemplary embodiment of the present invention. As shown in FIG. 4, the light absorption pattern 252 of the second substrate 210 is formed with a lattice pattern. The lattice-patterned light absorption pattern 252 may partition the emissive area EA of the organic light emitting diode 70 into a plurality of sub-emissive areas SEA. In another embodiment, the OLED display includes a light absorption pattern which includes both a stripe pattern and a lattice pattern (e.g., combined pattern). In another embodiment, the OLED display includes a light absorption pattern which includes a lattice configuration other than a rectangular or a square as shown in FIG. 4, for example, circular, pentagon or other polygonal shape. In another embodiment, the OLED display may not require an additional anti-reflection member as the light aborption pattern may function as an anti-reflection member.

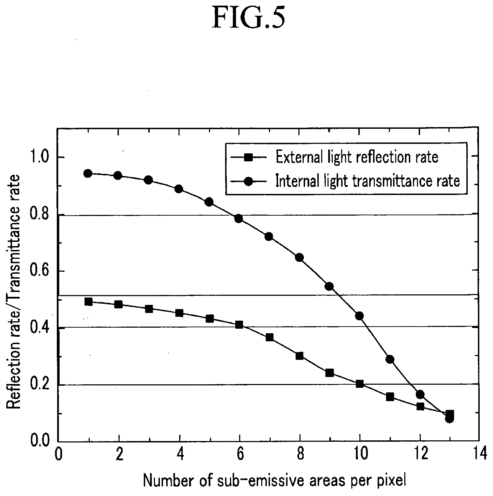

The efficiency of the reflection of external light and the efficiency of the transmittance of light emitted from the organic light emitting diode 70 as a function of the number of sub-emissive areas SEA per each pixel will now be described with reference to FIG. 5.

FIG. 5 is a graph illustrating the external light reflection rate and the internal light transmittance rate as a function of the number of sub-emissive areas SEA partitioned by the light absorption pattern 251 with a width of about 2 u m. The internal light transmittance indicates the transmittance of light emitted from the organic light emitting diode 70.

As shown in FIG. 5, the larger the number of sub-emissive areas SEA partitioned by the light absorption pattern 251 is, the more the external light reflection rate and the internal light transmittance are lowered.

In one embodiment, considering the appropriate prevention of external light reflection and the transmittance of light emitted from the organic light emitting diode 70, the number of sub-emissive areas SEA partitioned by the light absorption pattern 251 is four to ten. In another embodiment, the number of sub-emissive areas SEA partitioned by the light absorption pattern 251 is determined such that the external light reflection rate is about 0.45 or less and the internal light transmittance is about 0.55 or more. However, the external light reflection rate may be greater than about 0.45 and the internal light transmittance may be less than about 0.55 depending on embodiments.

While this invention has been described in connection with what is presently considered to be practical exemplary embodiments, it is to be understood that the invention is not limited to the disclosed embodiments, but, on the contrary, is intended to cover various modifications and equivalent arrangements included within the scope of the appended claims.

## Claims

1. An organic light emitting diode display (100) comprising
a first display panel (110) comprising a plurality of organic light emitting diodes, wherein an emissive area (EA) and a non-emissive area (NEA) are formed for each of the organic light emitting diodes, wherein the emissive area (EA) is configured to emit light, and wherein the non-emissive area (NEA) is configured not to emit light; and a second display panel (210) facing the first display panel (110), and wherein
the organic light emitting diode display comprises a light absorption pattern (251, 252) which partitions the emissive area (EA) of each organic light emitting diode into a plurality of sub-emissive areas (SEA),
**characterized in that**
the emissive area (EA) of each of the organic light emitting diodes is partitioned into four to ten sub-emissive areas (SEA) and
the light absorption pattern (251, 252) has a width of 1 to 9 micrometers, the width extending along a direction perpendicular to the longitudinal axis of the pattern units of the light absorption pattern (251, 252),
wherein the light absorption pattern (251) comprises a stripe pattern which comprises a plurality of stripes
and the emissive area (EA) of each of the plurality of organic light emitting diodes comprises a longish shape, and wherein the plurality of stripes are parallel with each other and cross the longitudinal axes of the emissive areas (EA) of each of the plurality of organic light emitting diodes, or
wherein the light absorption pattern (252) comprises a lattice pattern, wherein the lattice pattern comprises a first plurality of stripes and a second plurality of stripes which cross the first plurality of stripes, and wherein the first plurality of stripes and the second plurality of stripes cross the emissive areas (EA) of the organic light emitting diodes.

2. The organic light emitting diode display of claim 1, wherein a projection of the light absorption pattern (251, 252) onto the emissive area (EA) of the organic light emitting diodes partitions the emissive area (EA) of each organic light emitting diode into a plurality of sub-emissive areas (SEA), the projection extending along an axis which extends perpendicular to the surfaces of the first and second display panels (110, 210).

3. The organic light emitting diode display according to any one of the preceding claims, wherein the light absorption pattern (251, 252) contains one or more materials selected from the group consisting of titanium oxide, iron oxide, chromium and silver.

4. The organic light emitting diode display according to any one of the preceding claims, wherein the light absorption pattern (251, 252) comprises a black inorganic material.

5. The organic light emitting diode display according to any one of claims 1 to 4, wherein the light absorption pattern (251, 252) comprises an organic material containing black particulates.

6. The organic light emitting diode display of claim 5, wherein the black particulates comprise one or more materials selected from the group consisting of carbon black, tin, and tin alloys with an average diameter in a range of 1 nm to 300nm.

7. The organic light emitting diode display according to any one of the preceding claims, wherein the plurality of organic light emitting diodes is formed between the first and second display panels (110, 210); and each of the organic light emitting diodes comprises a driving thin film transistor (20) which is formed between the two display panels (110, 210) and configured to drive the organic light emitting diode; and wherein the light absorption pattern (251, 252) is directly formed on one of the two display panels (110, 210).

## Patentansprüche

1. Organische lichtemittierende Diodenanzeige (100), umfassend ein erstes Anzeigefeld (110), das eine Mehrzahl organischer lichtemittierender Dioden umfasst, wobei für jede der organischen lichtemittierenden Dioden ein emittierender Bereich (EA) und ein nichtemittierender Bereich (NEA) ausgebildet sind, wobei der emittierende Bereich (EA) gestaltet ist, Licht zu emittieren, und wobei der nichtemittierende Bereich (NEA) gestaltet ist, kein Licht zu emittieren; und ein dem ersten Anzeigefeld (110) gegenüberliegendes zweites Anzeigefeld (210), und wobei
die organische lichtemittierende Diodenanzeige ein Lichtabsorptionsmuster (251, 252) umfasst, das den emittierenden Bereich (EA) jeder organischen lichtemittierenden Diode in eine Mehrzahl emittierender Unterbereiche (SEA) unterteilt,
**dadurch gekennzeichnet, dass**
der emittierende Bereich (EA) jeder der organischen lichtemittierenden Dioden in vier bis zehn emittierende Unterbereiche (SEA) unterteilt ist und
das Lichtabsorptionsmuster (251, 252) eine Breite von 1 bis 9 Mikrometer aufweist, wobei sich die Breite entlang einer senkrecht zur Längsachse der Mustereinheiten des Lichtabsorptionsmusters (251, 252) verlaufenden Richtung erstrecken,
wobei das Lichtabsorptionsmuster (251) ein Streifenmuster umfasst, das eine Mehrzahl von Streifen umfasst,
und der emittierende Bereich (EA) jeder der Mehrzahl organischer lichtemittierender Dioden eine längliche Form umfasst und wobei die Streifen der Mehrzahl an Streifen parallel zueinander sind und die Längsachsen der emittierenden Bereiche (EA) jeder der Mehrzahl organischer lichtemittierender Dioden kreuzen oder
wobei das Lichtabsorptionsmuster (252) ein Gittermuster umfasst, wobei das Gittermuster eine erste Mehrzahl von Streifen und eine zweite Mehrzahl von Streifen, welche die erste Mehrzahl von Streifen kreuzt, umfasst und wobei die erste Mehrzahl von Streifen und die zweite Mehrzahl von Streifen die emittierenden Bereiche (EA) der organischen lichtemittierenden Dioden kreuzen.

2. Organische lichtemittierende Diodenanzeige nach Anspruch 1, wobei ein Vorsprung des Lichtabsorptionsmusters (251, 252) auf den emittierenden Bereich (EA) der organischen lichtemittierenden Dioden den emittierenden Bereich (EA) jeder organischen lichtemittierenden Diode in eine Mehrzahl emittierender Unterbereiche (SEA) unterteilt, wobei sich der Vorsprung entlang einer Achse erstreckt, die sich senkrecht zu den Oberflächen des ersten und des zweiten Anzeigefelds (110, 210) erstreckt.

3. Organische lichtemittierende Diodenanzeige nach einem der vorangehenden Ansprüche, wobei das Lichtabsorptionsmuster (251, 252) ein oder mehrere Materialien, ausgewählt aus der Gruppe bestehend aus Titanoxid, Eisenoxid, Chrom und Silber, beinhaltet.

4. Organische lichtemittierende Diodenanzeige nach einem der vorangehenden Ansprüche, wobei das Lichtabsorptionsmuster (251, 252) ein schwarzes anorganisches Material umfasst.

5. Organische lichtemittierende Diodenanzeige nach einem der Ansprüche 1 bis 4, wobei das Lichtabsorptionsmuster (251, 252) ein schwarze Partikel beinhaltendes organisches Material umfasst.

6. Organische lichtemittierende Diodenanzeige nach Anspruch 5, wobei die schwarzen Partikel ein oder mehrere Materialien, ausgewählt aus der Gruppe bestehend aus Carbon black, Zinn und Zinnlegierungen, mit einem durchschnittlichen Durchmesser in einem Bereich von 1 nm bis 300 nm umfassen.

7. Organische lichtemittierende Diodenanzeige nach einem der vorangehenden Ansprüche, wobei die Mehrzahl organischer lichtemittierender Dioden zwischen dem ersten und dem zweiten Anzeigefeld (110, 210) ausgebildet ist; und jede der organischen lichtemittierenden Dioden einen Treiber-Dünnschichttransistor (20) umfasst, der zwischen den beiden Anzeigefeldern (110, 210) ausgebildet und gestaltet ist, die organische lichtemittierende Diode anzutreiben; und wobei das Lichtabsorptionsmuster (251, 252) unmittelbar auf einem der beiden Anzeigefelder (110, 210) ausgebildet ist.

## Revendications

1. Dispositif d'affichage à diodes électroluminescentes organiques (100) comprenant :
un premier panneau d'affichage (110) comprenant une pluralité de diodes électroluminescentes organiques, dans lequel une zone émissive (EA) et une zone non émissive (NEA) sont formées pour chacune des diodes électroluminescentes organiques, dans lequel la zone émissive (EA) est configurée pour émettre de la lumière, et dans lequel la zone non émissive (NEA) est configurée pour ne pas émettre de la lumière ; et un deuxième panneau d'affichage (210) faisant face au premier panneau d'affichage (110), et dans lequel
le dispositif d'affichage à diodes électroluminescentes organiques comprend un motif d'absorption de lumière (251, 252) qui divise la zone émissive (EA) de chaque diode électroluminescente organique en une pluralité de sous-zones émissives (SEA),
**caractérisé en ce que**
la zone émissive (EA) de chacune des diodes électroluminescentes organiques est divisée en quatre à dix sous-zones émissives (SEA) et
le motif d'absorption de lumière (251, 252) a une largeur de 1 à 9 micromètres, la largeur s'étendant le long d'une direction perpendiculaire à l'axe longitudinal des unités de motif du motif d'absorption de lumière (251, 252),
dans lequel le motif d'absorption de lumière (251) comprend un motif à rayures qui comprend une pluralité de rayures
et la zone émissive (EA) de chacune de la pluralité de diodes électroluminescentes organiques comprend une forme oblongue, et où la pluralité de rayures sont parallèles les unes aux autres et traversent les axes longitudinaux des zones émissives (EA) de chacune de la pluralité de diodes électroluminescentes organiques, ou
dans lequel le motif d'absorption de lumière (252) comprend un motif en réseau, où le motif en réseau comprend une première pluralité de rayures et une deuxième pluralité de rayures qui traversent la première pluralité de rayures, et où la première pluralité de rayures et la deuxième pluralité de rayures traversent les zones émissives (EA) des diodes électroluminescentes organiques.

2. Dispositif d'affichage à diodes électroluminescentes organiques de la revendication 1, dans lequel une partie saillante du motif d'absorption de lumière (251, 252) sur la zone émissive (EA) des diodes électroluminescentes organiques divise la zone émissive (EA) de chaque diode électroluminescente organique en une pluralité de sous-zones émissives (SEA), la partie saillante s'étendant le long d'un axe qui s'étend de manière perpendiculaire aux surfaces des premier et deuxième panneaux d'affichage (110, 210).

3. Dispositif d'affichage à diodes électroluminescentes organiques selon l'une quelconque des revendications précédentes, dans lequel le motif d'absorption de lumière (251, 252) contient un ou plusieurs matériau(x) choisi(s) dans le groupe consistant en oxyde de titane, oxyde de fer, chrome et argent.

4. Dispositif d'affichage à diodes électroluminescentes organiques selon l'une quelconque des revendications précédentes, dans lequel le motif d'absorption de lumière (251, 252) comprend un matériau inorganique noir.

5. Dispositif d'affichage à diodes électroluminescentes organiques selon l'une quelconque des revendications 1 à 4, dans lequel le motif d'absorption de lumière (251, 252) comprend un matériau organique contenant des matières particulaires noires.

6. Dispositif d'affichage à diodes électroluminescentes organiques de la revendication 5, dans lequel les matières particulaires noires comprennent un ou plusieurs matériau(x) choisi(s) dans le groupe consistant en noir de carbone, étain et alliages d'étain avec un diamètre moyen se situant dans une plage de 1 nm à 300 nm.

7. Dispositif d'affichage à diodes électroluminescentes organiques selon l'une quelconque des revendications précédentes, dans lequel la pluralité de diodes électroluminescentes organiques est formée entre les premier et deuxième panneaux d'affichage (110, 210) ; et chacune des diodes électroluminescentes organiques comprend un transistor à couche mince d'attaque (20) qui est formé entre les deux panneaux d'affichage (110, 210) et configuré pour attaquer la diode électroluminescente organique ; et où le motif d'absorption de lumière (251, 252) est formé directement sur l'un des deux panneaux d'affichage (110, 210).
